# EUROPEAN PATENT APPLICATION

(11) **EP 4 543 180 A1**
(43) Date of publication of application: **23.04.2025**
(21) Application number: 23204090.7
(22) Date of filing: 17.10.2023
(51) Int. Cl.: H10K 59/80, H10K 77/10

(54) **STRESS-DISTRIBUTING LAYER FOR IMPROVED STRETCHABILITY OF THIN-FILMS ON SOFT SUB-STRATES WITH CORRUGATED SURFACES**

(71) Applicant: Flexucell ApS, 9750 Østervrå (DK)
(72) Inventor: LINNET, Jes, 5260 Odense (DK); Kjelstrup-Hansen, Jakob, 9750 Østervrå (DK); LARSEN, Jens William, 9330 Dronninglund (DK); Kiil, Hans-Erik, 6400 Sønderborg (DK)
(74) Representative: Patrade A/S

(57) **Abstract**

A flexible thin-film device (10) comprising
- a flexible polymer substrate (5) comprising a corrugated surface structure (8) comprising a pattern of waves, the waves following one or more curved lines and/or one or more straight lines;
- one or more functional layers (7) on the corrugated surface structure (8), the one or more functional layers (7) defining an upper surface (9) opposite to the corrugated surface structure (8); and
- a stress-distribution layer (6) comprising a flexible polymer layer on the upper surface (9).

## Description

### Field of the Invention

The present invention relates to a flexible thin-film device capable of being bent and stretched. In particular, the flexible thin-film device has a design wherein one or more functional layers are not required to be positioned in a neutral plane due to a corrugated surface structure of the substrate and a stress-distribution layer on an upper surface of one or more functional layers.

### Background of the Invention

The industry of flexible thin film devices is a growing industry. The most known example is probably smart phones with screens that are bendable if the screen is bent in a controlled motion. Said smart phone screens are not stretchable and are in fact brittle, when experiencing a tension force.

The functional layers of these screens are sandwiched between two layers such that any tension forces cancel out at the functional layers. Thereby, the force acted on the functional layers is minimized, hence it is called the neutral layer. The requirement of placing the functional layers within or at least close to the neutral layer increases the manufacturing complexity. The total thin-film thickness is limited by this requirement of manufacturing layers within the neutral layer, essentially some material will be out of the neutral plane, and worse for thicker layers. Furthermore, the 'neutral layer' method only improves the bending strength, the neutral layer method does not improve the tensile strength. Thus, there is a need for a flexible thin-film device which is not only bendable but also stretchable.

It would be an additional benefit if the resulting flexible thin-film can function without utilizing the neutral plan as this would lower the manufacturing tolerances.

### Object of the Invention

It is an object of the invention to provide a flexible thin-film device being both bendable and stretchable such that said flexible thin-film device becomes more versatile.

It is further an object of the invention to provide various uses for the flexible thin-film device.

### Description of the Invention

An object of the invention is achieved by a flexible thin-film device comprising
- a flexible polymer substrate comprising a corrugated surface structure comprising a pattern of waves, the waves following one or more curved lines and/or one or more straight lines;
- one or more functional layers on the corrugated surface structure, the one or more functional layers defining an upper surface opposite to the corrugated surface structure; and
- a stress-distribution layer comprising a flexible polymer layer on the upper surface.

The flexible thin-film device is both bendable and stretchable along at least one axis due to the pattern of waves or along two or more axes due to the pattern of waves. The flexible thin-film device may be twisted along certain axis depending on the design of the pattern of waves. However, the one or more functional layers will in most cases break if not for the stress-distribution layer (SDL) or at least be very brittle.

The pattern of waves defines the one or more axis which the flexible thin-film device is both bendable and stretchable along. As an example, a sinusoidal wave would cause the flexible thin-film device to be stretchable and compressible perpendicular to the wave front of the sinusoidal wave, thereby also allowing the thin-film to be bendable. The sinusoidal wave is the simplest example, but more complex waves will have one, two or three or more axes along which the flexible thin-film device is stretchable and compressible, thereby enabling more complex twisting and/or bending and/or stretching of the flexible thin-film devices.

Several flexible thin-film devices with functional layers for light emission on a flat surface without the stress-distribution layer have been manufactured for the purpose of testing the resilience to compression and tension force. However, roughly half of the flexible thin-film devices broke before testing was possible due to minor transportation between lab stations. While this may be reduced in the lab by a more elaborate transportation procedure, this fact shows that the flexible thin-film devices on a flat substrate such as a silicone substrate are not very suitable for commercial products. The equivalent flexible thin-film devices on a corrugated surface without a SDL could in most cases be moved between lab stations without breaking. However, some of the flexible thin-film devices break during transportation and this indicates that it would be beneficial if the stability of the flexible thin-film devices could be improved even further. Simulations show that addition of an SDL will improve the stability of the flexible thin-film device. The reason for the instability of the flexible thin-film devices is believed at least in part due to the substrate being a soft material such as silicone which can cause uncontrolled movement of the functional layers,

The pattern of waves may be along one or more straight lines. The straight lines may be parallel straight lines. The straight lines may be divided into two or more straight lines groups wherein the one or more straight lines within one group are mutually parallel. There may be two groups of straight lines wherein the straight lines from each group are substantially perpendicular. The one or more groups of straight lines may have the same amplitude and period or the amplitude and/or period may differ between the one or more groups.

The pattern of waves may be along one or more curved lines. The curved lines may be substantially sinusoidal curved lines extending horizontally in the flexible polymer substrate. The waves along the one or more curved lines still rise and fall between a maximum and a minimum as if the lines were straight.

The pattern of waves may be a combination of curved lines and straight lines.

The waves may have a sinusoidal shape or have part of a sinusoidal shape or be defined by two or more sinusoidal waves while still having a smooth continuous shape.

The flexible polymer substrate and the SDL may be made of the same material, but the materials may differ. The SDL can have a range of different thicknesses independently of the flexible polymer substrate since it is not required for the present solution to utilize the neutral plane by having the one or more functional layers in the neutral plane; see Table 1-7.

The one or more functional layers define an upper surface. The upper surface will change depending on the type of functional layers and number of functional layers. However, in all cases the SDL will be positioned on the upper surface.

In an aspect, the SDL may comprise a substantially plane top surface or a structured top surface when the flexible thin-film device is in a relaxed state. Thus, the highest point of the corrugated surface structure and one or more functional layers is at least covered by the stress distribution layer such that the stress in the one or more functional layers is reduced.

In an aspect, the flexible polymer substrate may be made of silicone, wherein the silicone is surface treated. The surface treatment changes the corrugated surface structure such that adherence between the one or more functional layers and the corrugated surface structure is increased. Thereby, the flexible thin-film device becomes more stable as the risk of the one or more functional layers releasing from the corrugated surface structure in decreased.

In an aspect, the silicone may be surface treated by a chemical surface treatment such as acid treatment and/or by electrons such as electrons from an electron beam. Both suggested methods will increase the adherence.

The electrons may cause part of the silicone surface to form SiOx.

In an aspect, the flexible polymer substrate may be made of silicone, wherein the corrugated surface being plasma treated thereby forming SiOx. The formed SiOx greatly increases the adherence between the corrugated surface structure and the one or more functional layers.

In an aspect, the stress distribution layer may have a thickness greater than two times the amplitude of the pattern of waves, wherein the thickness being measured from a minimum of the pattern of waves to a top surface of the stress distribution layer. The minimum of the pattern of waves will be the trough of the waves. The thickness greater than two times the amplitude means that the thickness will be greater than the distance between a crest and trough projected onto the normal of the flexible polymer substrate such that the entire structure is covered by the SDL. The SDL must cover the highest point of the substrate. Simulations have shown that this will decrease the average xx-component of the stress tensor integrated along the top surface of an oxide thin-film in two crossed lines. The same or similar result is expected if the oxide thin-film is substituted by the one or more functional layers.

In an aspect, the stress distribution layer may have a thickness at least 50 times greater or at least 100 times greater or 200 times greater or 300 times greater than the amplitude of the pattern of waves, wherein the thickness is measured from a trough of the pattern of waves to a top surface of the stress distribution layer. The simulations show that the stress-reducing effect is still present even at great material thickness of the stress distribution layer.

In an aspect, the pattern of waves may comprise a period to amplitude ratio between 0.3 to 50 or between 1 to 45 or between 5 to 30. The ratios mentioned ensure that the rate of change is not too great, thereby preventing good adherence, or too small, thereby causing the pattern of waves to be an approximation of a flat surface which would prevent or at least limit the flexibility of the thin-film. If the period to amplitude ratio is too great, then the rate of change will be so small that the surface will seem flat. A flat substrate surface will result in a non-stretchable device.

In an aspect, the one or more functional layers may comprise one or more of:
- one or more encapsulation layers, such as silicon oxides, silicon nitrides, metal oxides, or polymers; and/or
- one or more transparent electrode layers, such as transparent conductive oxides, nanowire-based solutions, metal grid designs, ultra-thin metal layers, or 2-dimensional materials; and/or
- one or more reflective electrode layers such as metal layers; and/or
- one or more organic thin-film layers comprising the active layers of an OLED stack, the OLED stack including organometallic layers, emitter layers, charge injection, transport and blocking layers; and/or
- one or more inorganic thin-film layers.

The functional layer or the functional layers can be chosen depending on the use or purpose of the flexible thin-film device.

In an aspect, the one or more functional layers may not be in a neutral plane between the flexible polymer substrate and the stress-distribution layer. The flexible thin-film device will function irrespective of the one or more functional layers being in the neutral plane.

In an aspect, the flexible polymer substrate and the stress distribution layer may be symmetric relative to the one or more functional layers. The flexible thin-film device will function irrespective of the one or more functional layers being in the neutral plane, however, the flexible thin-film device will still work if the one or more functional layers are positioned in the neutral plane.

In an aspect, the flexible thin-film device may be a light emitter and/or sensor and/or photoelectric device.

An object of the invention is achieved by use of a flexible thin-film device according to any of the preceding claims or mentioned embodiments in a stretched state on a surface such as a curved surface. The flexibility enables that the flexible thin-film device can be placed or adhered to a surface such as a curved surface in a stretched state, wherein the flexible thin-film device is in a stretched state.

An object of the invention is achieved by use of a flexible thin-film device according to any of the preceding claims in an initial planar state on a surface, wherein the surface changes dimensions over time. The flexible thin-film device will be able to adapt to the surface. Most surfaces will over time change, expand and retract due to changes in temperature and the change can over a year be quite significant. The flexibility increases the mechanical stability of the thin-film device. Some solar cells break after ten to twenty years due to mechanical changes over the years.

An object of the invention is achieved by use of flexible thin-film device according to any of the preceding claims on a stretchable surface, such as expanding polymer or rubber surface. Thereby, the flexible thin-film device can be used in cloth and function as a light emitter or a sensor or a combination. In the embodiments, where the flexible thin-film device is used in combination with cloth or fabric, the flexible thin-film device may also be twisted.

### Description of the Drawing

Embodiments of the invention will be described in the figures, whereon:
- Fig. 1: illustrates a plane sectional view of an embodiment of a flexible thin-film device in a relaxed state according to the invention.
- Fig. 2: illustrates a simulation of the stress distribution in a small section of a thinfilm in a flexible thin-film device subjected to 10% strain with and without a stress-distribution layer on top.
- Fig. 3: illustrates a simulating of the SDL thickness and material influence on the stress experience of a thin-film in a flexible thin-film device 10.

### Detailed Description of the Invention

| **Item** | **No** |
|---|---|
| Direction of stretch | S |
| Strained model (surface) | 1 |
| Unstrained model (wireframe) | 2 |
| Low Von Mises Stress | 3 |
| High Von Mises Stress | 4 |
| Flexible polymer substrate | 5 |
| Stress-distribution layer | 6 |
| Functional layer | 7 |
| Corrugated surface structure | 8 |
| Upper surface | 9 |
| Flexible thin-film device | 10 |
| Top surface | 11 |
| Relaxed state | 12 |
| Stretched state | 13 |
| Thickness | 14 |
| Neutral-plane in the sinusoidal function | 15 |

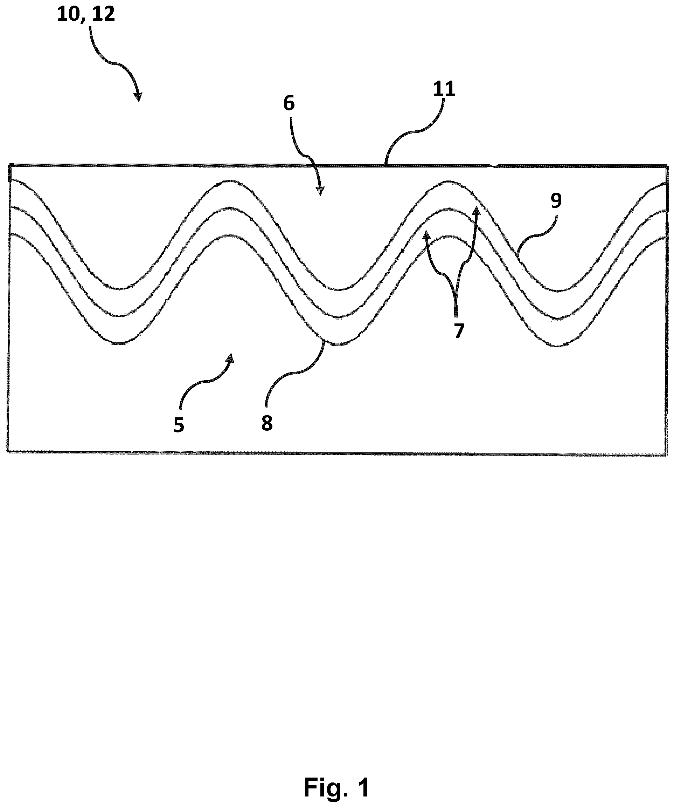

Figure 1 illustrates a plane sectional view of an embodiment of a flexible thin-film device 10 in a relaxed state 12 according to the invention. The flexible thin-film device 10 comprises a flexible polymer substrate 5 comprising a corrugated surface structure 8. The corrugated surface structure 8 comprises a pattern of waves, where the waves follow one or more curved lines and/or one or more straight lines. The flexible thin-film device 10 further comprises one or more functional layers 7 on the corrugated surface structure 8 of the flexible polymer substate 5. Figure 1 illustrates two functional layers 7 for merely an illustrative purpose.

The flexible polymer substrate 5 may be made of silicone, wherein the silicone is surface treated. The surface treatment changes the corrugated surface structure 8 such that adherence between the one or more functional layers 7 and the corrugated surface structure 8 is increased. The silicone may be surface treated by a chemical surface treatment such as an acid treatment and/or by electrons such as electrons from an electron beam. Both suggested methods will increase the adherence. The electrons may cause part of the silicone surface to form SiOₓ.

The flexible polymer substrate 5 may be made of silicone, wherein the corrugated surface 8 is plasma treated, thereby forming SiOₓ. The formed SiOₓ greatly increases the adherence between the corrugated surface structure 8 and the one or more functional layers 7.

The one or more functional layers 7 define an upper surface 9 opposite to the corrugated surface structure 8, and a SDL 6 comprising a flexible polymer layer is deposited on the upper surface 9 of the one or more functional layers 7. The upper surface 9 will change depending on the type of functional layers 7 and number of functional layers 7. However, in all cases the SDL 6 will be positioned on the upper surface 9.

The SDL 6 may comprise a substantially plane top surface 11 when the flexible thin-film device 10 is in a relaxed state 12. Thus, the highest point of the corrugated surface structure 8 and one or more functional layers 7 is at least covered by the SDL 6 such that the stress in the one or more functional layers 7 is reduced. The plane top surface 11 further ensures that the one or more functional layers 7 will experience a similar stress, when the flexible thin-film device 10 experiences tension forces or torsion forces.

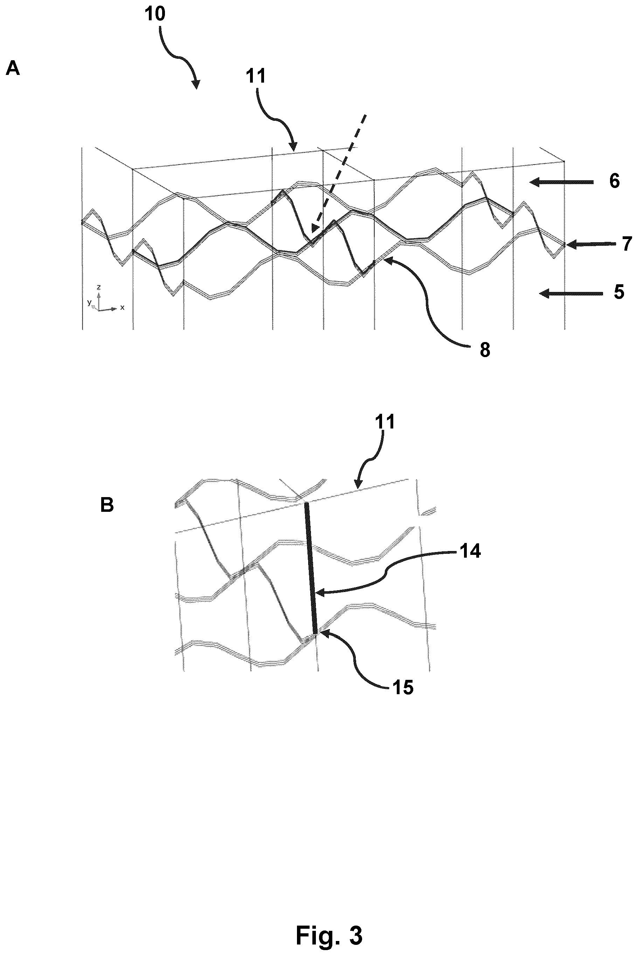

The flexible polymer substrate 5 and the SDL 6 may be made of the same material, but the material may also differ. The stress-distribution layer 6 can have a range of different thicknesses independently of the flexible polymer substrate 5 since it is not required for the present solution to utilize the neutral plane 15 by having the one or more functional layers 7 in the neutral plane 15 (see figure 3).

The stress-distribution layer 6 may have a thickness greater than the amplitude of the pattern of waves, wherein the thickness 14 is measured from the neutral plane 15 of the pattern of waves to a top surface 11 of the SDL (see figure 3B). The SDL 6 may have a thickness at least 50 times greater or at least 100 times greater or 200 times greater or 300 greater than the amplitude of the pattern of waves.

The pattern of waves may be along one or more straight lines. The straight lines may be parallel straight lines. The straight lines may be divided into two or more straight lines groups wherein the one or more straight lines within one group are mutually parallel. There may be two groups of straight lines wherein the straight lines from each group are substantially perpendicular. The one or more groups of straight lines may have the same amplitude and period or the amplitude and/or period may differ between the one or more groups.

The pattern of waves may be along one or more curved lines. The curved lines may be substantially sinusoidal curved lines extending horizontally in the flexible polymer substrate 5. The waves along the one or more curved lines still rise and fall between a maximum and a minimum as if the lines were straight.

The pattern of waves may be a combination of curved lines and straight lines.

The waves may have a sinusoidal shape or have part of a sinusoidal shape or be defined by two or more sinus waves while still having a smooth continuous shape.

The pattern of waves may comprise a period to amplitude ratio between 0.3 to 50 or between 1 to 45 or between 5 to 30.

The one or more functional layers 7 may comprise one or more of:
- one or more encapsulation layers, such as silicon oxides, silicon nitrides, metal oxides, or polymers; and/or
- one or more transparent electrode layers, such as transparent conductive oxides, nanowire-based solutions, metal grid designs, ultra-thin metal layers, or 2-dimensional materials; and/or
- one or more reflective electrode layers such as metal layers; and/or
- one or more organic thin-film layers comprising the active layers of an OLED stack, the OLED stack including organometallic layers, emitter layers, charge injection, transport and blocking layers; and/or
- one or more inorganic thin-film layers.

In some embodiments, the one or more functional layers 7 may not be in a neutral plane 15 between the flexible polymer substrate 5 and the stress-distribution layer 6. In other embodiments, the flexible polymer substrate 5 and the stress-distribution layer 6 may be symmetric relative to the one or more functional layers 7.

The flexible thin-film device 10 is both bendable and stretchable along at least one dimension due to the pattern of waves. However, the one or more functional layers 7 will in most cases break if not for the stress-distribution layer 6 or at least be very brittle.

In some embodiments, the flexible thin-film device 10 may be a light emitter and/or sensor and/or photoelectric device.

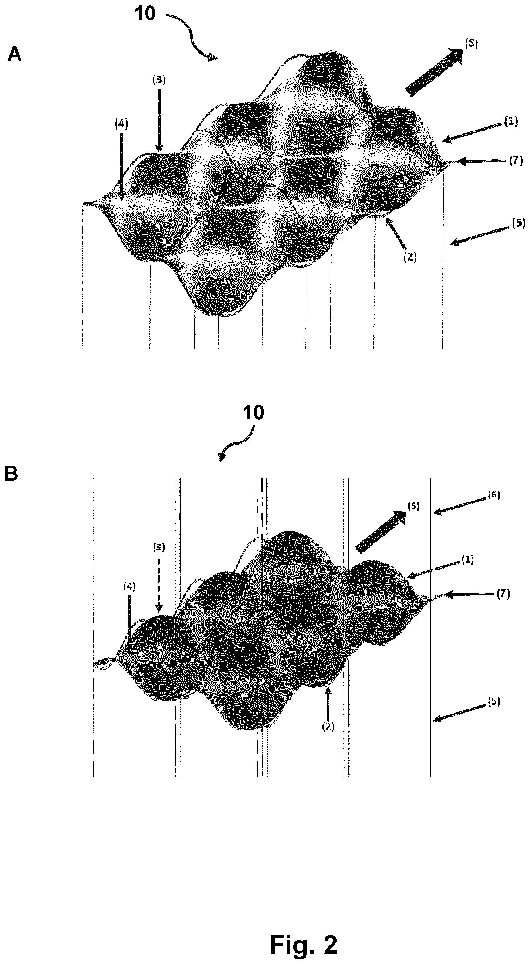

Figure 2 illustrates a simulation of the stress distribution in a small section of a thin-film in a flexible thin-film device 10 subjected to 10% strain with and without a stress-distribution layer 6 on top, where figure 2A is a simulation of a 100 nm SiO₂ coating with no stress-distribution layer 6 on top and figure 2B is a simulation of a 100 nm SiO₂ coating with a stress-distribution layer 6 on top.

When the flexible polymer substrate 5 with a corrugated surface structure 8 is stretched, the wavelength of the surface waves will increase with a corresponding reduction in amplitude. Essentially, when this type of flexible polymer substrate 5 experiences stretching globally, the surface will locally bend to accommodate part of the strain. However, parts of the corrugated surface 8 will still experience some tensile strain.

The SDL 6 can be made from the same or another form of substrate material as the flexible polymer substrate 5, however, in this simulation it is demonstrated as being the same material as the flexible polymer substrate 5 material, namely silicone. In figures 2A and 2B, a small section of the flexible polymer substrate 5 with thin-film coated surface (100 nm SiO₂ coating) corrugations 7 is subjected to 10% strain, i.e., the sample is stretched by pulling along the arrow S. The initially unstrained model 2 is indicated by a graphical wireframe rendering of vertical lines and sinusoidal waves and the strained model 1 as a black and white (grayscale) surface overlayed on top of the unstrained model 2. The grayscale on the strained surface 1 indicates Von Mises Stress ranging from low 3 to high 4 indicated by black 3 and white 4, respectively (grayscale 0 (black) - 5 (white) GPa Von Mises Stress). The vertical wireframe lines indicate flexible polymer substrate 5 below the corrugated surface 8 and the stress-distribution layer 6 above the corrugated surface 8.

As seen in figure 2A, the stress in the thin-film 7 on top of the corrugated surface structure 8 in a stretched state 13 is not evenly distributed across the peaks and troughs of the corrugations. When including a stress-distribution layer 6 by sandwiching it onto the thin-film 7 on the corrugated surface structure 8, the stress distribution becomes more uniform (figure 2B). Comparing figure 2A with no stress-distribution layer 6 above the corrugated surface 8 and figure 2B that includes the stress-distribution layer 6, the maximum Von Mises Stress calculated for the thin-film layers 7 is reduced by approximately 50% relative to the calculated maximum Von Mises Stress for the structure without the stress-distribution layer 6 comprising a flexible polymer. Thus, the stress is reduced by approximately 50% in the case where the stress-distribution layer 6 is included (figure 2B).

The stress-distribution layer 6 lowers the surface strain compared to the situation without the stress-distribution layer 6, when added onto the corrugated upper surface 9 of the one or more functional layers 7. Thus, the thin-film will experience a significantly lower level of stress, which will bring significantly longer lifetime for the flexible thin-film device 10.

The flexible thin-film device 10 with the stress-distribution layer 6 can therefore be installed on surfaces, which cause stretching of the flexible thin-film device 10, e.g., surfaces with smaller radius of curvature, and still maintain their function and lifetime.

The reduction of stress illustrated in figure 2 is shown for the specific example of an SiO₂ thin-film coating. However, the invention of the stress-distribution layer 6 can serve as a stress-distributor for other single layer or multilayer structures used within OLED technology as well. This includes encapsulation layers (silicon oxides and nitrides, metal oxides, polymers), transparent electrode layers (transparent conductive oxides, nanowire-based solutions, metal grid designs, ultra-thin metal layers, and 2-dimensional materials), reflective electrode layers (metal layers), and organic thin-film layers constituting the active layers of the OLED stack (organometallic layers, emitter layers, charge injection, transport and blocking layers).

Figure 3 illustrates a simulation of the stress-distribution layer (SDL) 6 thickness 14 and material influence on the stress experience of a thin-film 7 in a flexible thin-film device 10.

Several flexible thin-film devices 10 with functional layers 7 for light emitting without the stress-distribution layer 6 were manufactured for the purpose of testing the resilience to compression and tension force. However, all the flexible thin-film devices 10 broke before testing was possible due to minor transportation between lab stations. The equivalent flexible thin-film devices 10 with a stress-distribution layer 6 could be moved between lab stations without breaking.

The stress-distribution layer 6 can have a range of different thicknesses independently of the flexible polymer substrate 5 since it is not required for the present solution to utilize the neutral plane 15 by having the one or more functional layers 7 in the neutral plane 15. The thickness 14 of the stress-distribution layer 6 is not constant since the flexible polymer substrate 5 comprises a corrugated surface structure 8, so thickness 14 is defined as the distance between the top surface 11 of the stress-distribution layer 6 and the neutral-plane 15 in the sinusoidal function defining the wave pattern of the corrugated surface structure 8, as illustrated in figure 3B.

The finite-element material analysis studying the effects of the stress-distribution layer 6 indicates that there is a structurally mechanical advantage to having the stress-distribution layer 6 rather than leaving the upper layer 9 of the one or more functional layers 7 exposed.

To compare various stress-distribution layer 6 thicknesses 14 and materials influence on the stress experience by a 3D wave pattern oxide layer 7, a single average value (Sₓₓ) is extracted from the model for each combination studied. The extracted value is the average xx-component of the stress tensor integrated along the upper surface 9 of the 3D wave pattern oxide thin-film 7 in two crossed lines (see the dotted arrow in fig. 3A).

A broad selection of stretchable materials with varying densities and young's moduli were studied (table 1).

| **Table 1** | | | | | |
|---|---|---|---|---|---|
| | **Datasheet Silicone 1** | **Elastosil RT745** | **Datasheet Silicone 2** | **Elastosil RT745 (Low)** | **Elastosil RT745 (Mid)** |
| **Density (kg/m³)** | 1273 | 964 | 1700 | 964 | 964 |
| **Young's modulus (MPa)** | 4.2 | 50 | 25 | 1 | 25 |
| **Poisson's ratio** | 0.48 | 0.48 | 0.48 | 0.48 | 0.48 |

When computing the Sₓₓ for the selected thicknesses 14, it is seen that there is a small thickness dependence on the overall Sₓₓ values. A thicker stress-distribution layer (SDL) 6 computes a larger average stress tensor x-components (tables 2-6). It should be noted, however, that the dependence on thickness 14 is very little; increasing the thickness 333-fold (from 1.2 µm to 400 µm) gives a 9.2% increase in Sₓₓ. If there are negative x-components (compression) contributions to the average, the average Sₓₓ values will be lowered, therefore the average of the absolute value of the x-component is also presented in tables 2-6. It can be seen in tables 2-6 that there are indeed calculated contributions to the average that are negative, indicating that some areas of the 3D wave pattern oxide thin-film 7 will experience compressive stresses when stretching the flexible polymer substrate 5. The absolute value of Sₓₓ is on average 37% larger than Sₓₓ, indicating that roughly two thirds of the stress experienced by the 3D wave pattern oxide thin-film 7 is tensile and one third is compressive.

| **Table 2** | | |
|---|---|---|
| **SDL thickness = 1.2 µm** | | |
| **Material** | **Sₓₓ abs (MPa)** | **Sₓₓ (MPa)** |
| Datasheet Silicone 1 | 446.10 | 325.12 |
| Elastosil RT745 | 470.45 | 361.44 |
| Datasheet Silicone 2 | 457.78 | 342.18 |
| Elastosil RT745 (low) | 444.38 | 322.39 |
| Elastosil RT745 (mid) | 457.78 | 342.18 |

| **Table 3** | | |
|---|---|---|
| **SDL thickness = 2.2 µm** | | |
| **Material** | **Sₓₓ abs (MPa)** | **Sₓₓ (MPa)** |
| Datasheet Silicone 1 | 446.05 | 325.49 |
| Elastosil RT745 | 470.41 | 366.60 |
| Datasheet Silicone 2 | 457.76 | 344.73 |
| Elastosil RT745 (low) | 444.34 | 322.43 |
| Elastosil RT745 (mid) | 457.76 | 344.73 |

| **Table 4** | | |
|---|---|---|
| **SDL thickness = 3.2 µm** | | |
| **Material** | **Sₓₓ abs (MPa)** | **Sₓₓ (MPa)** |
| Datasheet Silicone 1 | 446.33 | 325.76 |
| Elastosil RT745 | 472.46 | 369.10 |
| Datasheet Silicone 2 | 459.08 | 346.15 |
| Elastosil RT745 (low) | 444.40 | 322.50 |
| Elastosil RT745 (mid) | 459.08 | 346.15 |

| **Table 5** | | |
|---|---|---|
| **SDL thickness = 4.2 µm** | | |
| **Material** | **Sₓₓ abs (MPa)** | **Sₓₓ (MPa)** |
| Datasheet Silicone 1 | 446.69 | 326.05 |
| Elastosil RT745 | 474.77 | 371.17 |
| Datasheet Silicone 2 | 460.64 | 347.48 |
| Elastosil RT745 (low) | 444.46 | 322.55 |
| Elastosil RT745 (mid) | 460.64 | 347.48 |

| **Table 6** | | |
|---|---|---|
| **SDL thickness = 400 µm** | | |
| **Material** | **Sₓₓ abs (MPa)** | **Sₓₓ (MPa)** |
| Datasheet Silicone 1 | 489.16 | 355.56 |
| Elastosil RT745 | 569.12 | 410.23 |
| Datasheet Silicone 2 | 541.37 | 377.29 |
| Elastosil RT745 (low) | 491.19 | 364.27 |
| Elastosil RT745 (mid) | 541.37 | 377.29 |

Since the thickness 14 variation has relatively little influence on the experienced stresses of the 3D wave pattern oxide thin-film 7, it can be hypothesized that the stress-distribution layer's 6 working principle is that by filling out the gaps between the peaks of the 3D wave pattern with a flexible polymer, the troughs and peaks are equally supported by the flexible polymer during stretching. Thus, the stress-distribution layer 6 may provide structural stability in the sinusoidal function defining the 3D wave pattern oxide thin-film 7.

Further material selections studied employ very low young's modulus (MPa) which may occur in commercially available flexible substrate materials. The already low young's modulus material (Elastosil RT745 (low)) is further reduced in young's modulus and the Sₓₓ studied (table 7). A tendency is seen that a lower young's modulus is favorable, since Sₓₓ computes to lower average values when reducing the young's modulus for the same material. However, the young's moduli are not that impactful on the stress-reducing effect of the stress-distribution layer 6, when comparing similar materials with young's modulus of 0.1 MPa and young's modulus of 50 MPa. Thus, a 500-fold increase in young's modulus only gives a 15.4% increase in Sₓₓ.

| **Table 7** | | |
|---|---|---|
| **Elastosil RT745 (low)** | | |
| **Young's modulus (MPa)** | **Sₓₓ abs (MPa)** | **Sₓₓ (MPa)** |
| 0.1 | 443.81 | 321.55 |
| 0.2 | 443.89 | 321.66 |
| 0.3 | 443.96 | 321.77 |
| 0.4 | 444.03 | 321.88 |
| 0.5 | 444.10 | 321.99 |
| 0.75 | 444.28 | 322.27 |
| 1 | 444.46 | 322.55 |

In conclusion, using finite-element material analysis only small differences in computed stresses are calculated when changing material parameters and thicknesses 14 of the stress distribution layer 6. The computed stress of the oxide thin-film surface 7 is increased for higher young's modulus. However, a 500-fold increase only increased computed stress on the oxide thin-film surface 7 by 15.4%. The thickness 14 also has influence on the stress, as a 333 times thicker stress-distribution layer 6 only equates a stress increase of 9.2%. Therefore, there is a strong indication that the stress-distribution layer 6 improves stability of flexible thin-film devices 10 utilizing a wide variety of materials. It is furthermore indicated that the stress-distribution layer's 6 influence provides a symmetrical and stable platform by filling the gaps between the peaks of the 3D wave pattern with flexible polymers.

## Claims

1. A flexible thin-film device (10) comprising
- a flexible polymer substrate (5) comprising a corrugated surface structure (8) comprising a pattern of waves, the waves following one or more curved lines and/or one or more straight lines;
- one or more functional layers (7) on the corrugated surface structure (8), the one or more functional layers (7) defining an upper surface (9) opposite to the corrugated surface structure (8); and
- a stress-distribution layer (6) comprising a flexible polymer layer on the upper surface (9).

2. A flexible thin-film device (10) according to claim 1, wherein stress distribution layer (6) comprises a substantially plane top surface (11) or a structured top surface (11) when the flexible thin-film device (10) is in a relaxed state (12).

3. A flexible thin-film device (10) according to any of the preceding claims, wherein the flexible polymer substrate (5) is made of silicone, wherein the silicone is surface treated.

4. A flexible thin-film device (10) according to claim 3, wherein the silicone is surface treated by a chemical surface treatment such as acid treatment and/or by electrons such as electrons from an electron beam.

5. A flexible thin-film device (19) according to any of the preceding claims, wherein the flexible polymer substrate (5) is made of silicone, wherein the corrugated surface (8) being plasma treated thereby forming SiOx.

6. A flexible thin-film device (10) according to any of the preceding claims, wherein the stress distribution layer (6) has a thickness (14) greater than two times the amplitude of the pattern of waves, wherein the thickness (14) is measured from a minimum of the pattern of waves to a top surface (11) of the stress distribution layer (6).

7. A flexible thin-film device (10) according to any of the preceding claims, wherein the stress distribution layer (6) has a thickness (14) at least 50 times greater or at least 100 times greater or 200 times greater or 300 greater than the amplitude of the pattern of waves, wherein the thickness (14) is measured from a trough of the pattern of waves to a top surface (11) of the stress distribution layer (6).

8. A flexible thin-film device (10) according to anyone of claims 1 to 7, wherein pattern of waves comprises a period to amplitude ratio between 0.3 to 50 or between 1 to 45 or between 5 to 30.

9. A flexible thin-film device (10) according to anyone of claims 1 to 8, wherein the one or more functional layers (7) comprise one or more of:
- one or more encapsulation layers, such as silicon oxides, silicon nitrides, metal oxides, or polymers; and/or
- one or more transparent electrode layers, such as transparent conductive oxides, nanowire-based solutions, metal grid designs, ultra-thin metal layers, or 2-dimensional materials; and/or
- one or more reflective electrode layers such as metal layers; and/or
- one or more organic thin-film layers comprising the active layers of an OLED stack, the OLED stack including organometallic layers, emitter layers, charge injection, transport and blocking layers; and/or
- one or more inorganic thin-film layers.

10. A flexible thin-film device (10) according to anyone of claims 1 to 9, wherein the one or more functional layers (7) are not in a neutral plane between the flexible polymer substrate (5) and the stress-distribution layer (6).

11. A flexible thin-film device (10) according to anyone of claims 1 to 9, wherein the flexible polymer substrate (5) and the stress distribution layer (6) are symmetric relative to the one or more functional layers (7).

12. A flexible thin-film device (10) according to any of the preceding claims, wherein the flexible thin-film device (10) is a light emitter and/or sensor and/or photoelectric device.

13. Use of a flexible thin-film device (10) according to any of the preceding claims in a stretched state (13) on a surface such as a curved surface.

14. Use of a flexible thin-film device (10) according to any of the preceding claims in an initial planar state on a surface, wherein the surface changes dimensions over time.

15. Use of flexible thin-film device (10) according to any of the preceding claims on a stretchable surface, such as expanding polymer or rubber surface.
